# EUROPÄISCHE PATENTSCHRIFT

(11) **EP 2 656 407 B1**
(45) Veröffentlichungstag und Bekanntmachung des Hinweises auf die Patenterteilung: **11.02.2015**
(21) Anmeldenummer: 11782417.7
(22) Anmeldetag: 10.11.2011
(51) Int. Cl.: H01L 41/047, H02N 2/06

(54) **AKTORSYSTEM UND ANSTEUERUNG EINES AKTORS**
ACTUATOR SYSTEM, AND ACTUATION OF AN ACTUATOR
SYSTÈME D'ACTIONNEUR ET COMMANDE D'UN ACTIONNEUR

(30) Priorität: 22.12.2010 DE 102010055620
(43) Veröffentlichungstag der Anmeldung: 30.10.2013
(73) Patentinhaber: Epcos AG, 81669 München (DE)
(72) Erfinder: AUER, Christoph, A-8043 Graz (AT); GABL, Reinhard, A-6330 Kufstein (AT)
(74) Vertreter: Epping - Hermann - Fischer
(86) Internationale Anmeldenummer: PCT/EP2011/069853
(87) Internationale Veröffentlichungsnummer: WO 2012/084334

(56) Entgegenhaltungen:
- DE-A1-102004 025 073
- US-A- 5 686 777

## Beschreibung

Aktoren, beispielsweise Vielschichtaktoren, werden auf verschiedenen Gebieten eingesetzt, ein Beispiel sind Einspritzsysteme für Motoren. Ein Problem bei sehr kurzen Schaltzeiten, das heißt bei hochdynamischen Anwendungen, ist die Sicherstellung eines dauerhaften Betriebs. Dieses Problem tritt beispielsweise bei Verbrennungsmotoren auf. Für einen effizienten Betrieb von Verbrennungsmotoren ist es vorteilhaft, wenn die Nadel des Einspritzsystems gut regulierbar und schnell geöffnet und geschlossen werden kann. Zu diesem Zweck kann in Einspritzsystemen die Nadelsteuerung durch piezoelektrische Aktoren erfolgen. Bei Anwendungen in Automotoren müssen diese Aktoren dauerhaft mit sehr steilen Ansteuerflanken betrieben werden können. Probleme bei solch hochdynamischer Ansteuerung von Aktoren können sich auf Grund von Trägheitskräften, die zu mechanischen Zugspannungen führen, ergeben. Diese Zugspannungen können unkontrolliertes Risswachstum im Keramikkörper des Aktors bewirken und so potenziell zum Ausfall des Bauteils führen. Bei der Direktsteuerung mit langen Aktoren und kurzen Schaltzeiten verschärft sich das Problem des Auftretens von Zugspannungen durch Trägheitskräfte.

Dieses Problem kann durch eine äußere mechanische Vorspannung des Aktors gelöst werden. Durch Anlegen einer äußeren Vorspannkraft kann das Spannungsniveau im Aktor in den Druckbereich verschoben werden. Die mechanische Vorspannung kann über ein Federsystem angelegt werden. Hier wird ein zuverlässiges System mit hoher Vorspannkraft und gleichzeitig niedriger Steifigkeit zur Verringerung der zusätzlichen Last des Aktors gewünscht, sowie geringe Bewegung der Masse zur Verringerung der zusätzlichen Trägheitskräfte. Zudem hängt das Auslenkungsvermögen der Aktoren von der Vorspannkraft ab. Bei hohen Vorspannkräften reduziert sich die Auslenkung von Piezoaktoren bei gleicher elektrischer Ansteuerung, das heißt bei gleicher Ladeenergie, stark.

Die DE 10 2004 025073 A1 zeigt eine Anordnung übereinander gestapelter piezoelektrischer Einheiten, deren Außenelektroden voneinander separiert sind.

Die US 5 686 777 A zeigt einen aufeinander geschichteten piezoelektrischen Stapel.

Es stellt sich die Aufgabe einen hinsichtlich der oben genannten Aspekte verbesserten Aktor bereitzustellen.

Die Aufgabe wird durch ein Aktorsystem mit den Merkmalen des Patentanspruchs 1 gelöst. Es umfasst einen Aktor mit stapelförmig angeordneten Piezoelementen, ersten und zweiten Innenelektroden, die zwischen den Piezoelementen abwechselnd angeordnet sind, einer ersten Außenelektrode, die elektrisch leitend mit den ersten Innenelektroden verbunden ist, und einer zweiten Außenelektrode, die elektrisch leitend mit den zweiten Innenelektroden verbunden ist, vorgesehen. Der Aktor umfasst eine Vielzahl von Aktorabschnitten, und die zweite Außenelektrode umfasst separate Elektrodensegmente, die jeweils mit den zweiten Innenelektroden in einem der Aktorabschnitte elektrisch leitend verbunden sind. Jeder Aktorabschnitt ist nur mit einem Teil der zweiten Innenelektroden elektrisch leitend verbunden. Die separaten, sich nicht berührenden oder nicht direkt elektrisch leitend miteinander verbundenen Elektrodensegmente erlauben die Aktorabschnitte zeitlich versetzt anzusteuern, sodass der Dehnungsvorgang nicht für alle Piezoelemente zeitgleich in Gang gesetzt wird, sondern zeitlich versetzt. Der Zeitversatz wird in Abhängigkeit der Trägheitskräfte im Aktor gewählt.

Der Aktor umfasst mehrere Abschnitte, jeweils mit Piezoelementen und Innenelektroden, welche zeitversetzt angesteuert werden. Die Ansteuerung erfolgt nicht gleichzeitig für alle Bereiche des gesamten Aktors, sondern erfolgt zeitversetzt für deren einzelne Abschnitte. In vorteilhafter Weise wird der Zeitversatz so gewählt, dass er exakt der Schallgeschwindigkeit im Aktor entspricht. Dadurch überlagern sich beim Ausdehnen des Aktors die elastischen Teilwellen derart, dass sich eine wesentlich kürzere Flankenzeit ergibt für die Ausdehnung des Aktors als dies bei gleichzeitiger Ansteuerung der Außenelektrode der Fall wäre. Die untere Grenze der Flankenzeit wird nicht mehr durch die Länge des gesamten Aktors begrenzt, sondern durch die Länge der einzelnen Bereiche.

Auf Grund der zeitlich versetzten elektrischen Ansteuerung von örtlich getrennten Elektrodensegmenten können somit die elastischen Dehnungen im Aktor, die im hochdynamischen Betrieb auf Grund von Trägheitskräften entstehen, gezielt mit den piezoelektrischen Dehnungen kompensiert werden. Die zeitversetzte Ansteuerung ermöglicht das mechanische Spannungsniveau im Aktor besser zu kontrollieren, und ein dauerhafter Betrieb mit kurzen Schaltzeiten wird sichergestellt. Eine solche sequentielle Ansteuerung der Aktorabschnitte wird durch die segmentierte Außenelektrode erreicht. Ein weiterer Vorteil dieser Lösung ist, dass keine Erhöhung einer statischen Vorspannkraft erforderlich ist und diesbezüglich auch keine konstruktiven Maßnahmen an einem Vorspannsystem und dem Aktor anfallen. Diese Möglichkeit zur Vermeidung von Zugspannung ist gut geeignet für lange Aktoren, wie sie zur Direktsteuerung der Ventilnadel benötigt werden. Die gezielte elektrische Ansteuerung von Aktorabschnitten dient zur Reduzierung von elastischen Dehnungen, die durch Trägheitskräfte im hochdynamischen Betrieb verursacht werden. Die Zeitverzögerung zwischen den Ansteuerungen der Aktorabschnitte wird so gewählt, dass die elastischen Dehnungen kompensiert oder reduziert werden. Durch die gezielte elektrische Ansteuerung der Aktorabschnitte werden die elastischen Dehnungen reduziert, die durch Trägheitskräfte im hochdynamischen Betrieb verursacht werden.

Weitere vorteilhafte Ausgestaltungen der Erfindung sind in den abhängigen Patentansprüchen angegeben.

Nachfolgend wird die Erfindung unter Bezugnahme auf die Zeichnungen anhand von Ausführungsbeispielen erklärt.

Es zeigen:
- Figur 1: ein Ausführungsbeispiel eines Aktors ohne segmentierte Außenelektroden,
- Figur 2: ein Ausführungsbeispiel eines Aktors mit einer segmentierten Außenelektrode,
- Figur 3: ein Modell zur Simulation des dynamischen Betriebs eines Aktors mit segmentierter Außenelektrode im Vergleich zu einem Aktor ohne segmentierte Außenelektrode,
- Figur 4: die Ansteuerung des Simulationsmodells in Figur 3, wobei der mit Strom über der Zeit dargestellt ist,
- Figur 5: Details aus Figur 4,
- Figur 6: die Auslenkung über der Zeit,
- Figur 7: die Kraft über der Zeit am fixierten Aktorfuß,
- Figur 8: Details aus Figur 6, und
- Figur 9: Details aus Figur 7.

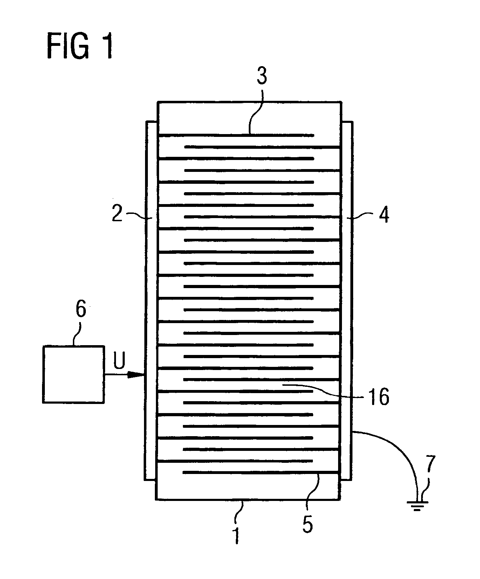

Figur 1 zeigt eine schematische Schnittdarstellung eines konventionellen Vielschichtaktors 1 mit stapelförmig angeordneten Piezoelementen 16. Erste Innenelektroden 5 und zweite Innenelektroden 3 sind zwischen den Piezoelementen 16 abwechselnd angeordnet. Die ersten Innenelektroden 5 sind elektrisch leitend mit einer ersten Außenelektrode 4 verbunden. Die zweiten Innenelektroden 3 sind elektrisch leitend mit einer zweiten Außenelektrode 2 verbunden. Die ersten und zweiten Innenelektroden 5 und 3 sind jeweils zu einer Außenseite des Aktors 1 geführt und werden dort mit der ersten Außenelektrode 4 beziehungsweise zweiten Außenelektrode 2 elektrisch leitend verbunden. Dies kann beispielsweise durch Aufdrucken einer Metallpaste oder durch Anlöten von metallischen Platten erfolgen, welche die Außenelektroden 4, 2 bilden.

Die erste Außenelektrode 4 ist mit einem Bezugspotenzial 7 verbunden. Eine Steueranordnung 6 legt an die zweite Außenelektrode 2 ein Ansteuersignal, beispielsweise ein zeitveränderliches Ansteuerpotenzial an, sodass zwischen den ersten und zweiten Innenelektroden eine Ansteuerspannung liegt, in Abhängigkeit derer der Aktor 1 gedehnt oder gestaucht wird.

Durch Anlegen der Ansteuerspannung erfährt der Aktor 1 einen Hub. Die Ausdehnung des Aktors 1 erfolgt in endlicher Zeit. Durch Anlegen einer entgegen gesetzten Spannung wird der Aktor 1 gestaucht.

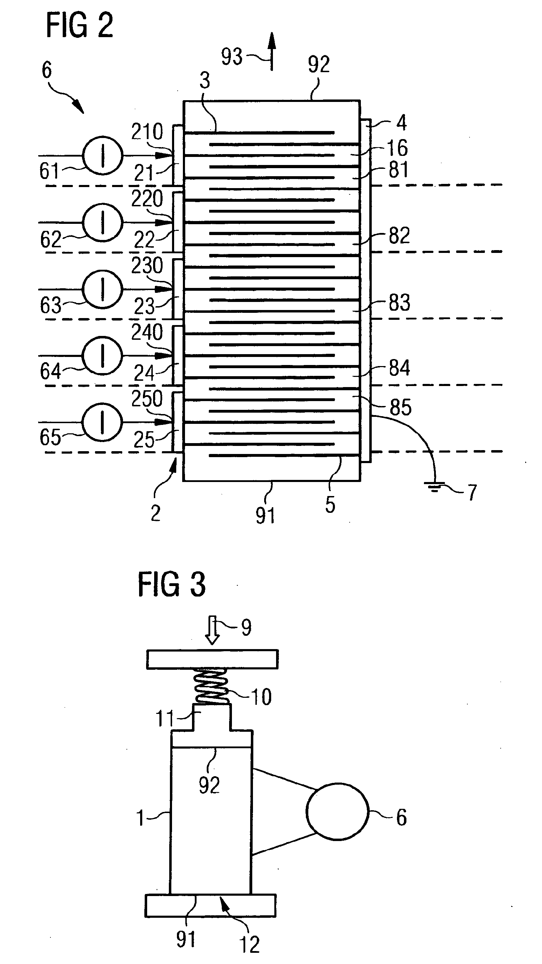

Figur 2 zeigt ein Ausführungsbeispiel eines Vielschichtaktors 1 mit einer ersten Außenelektrode 4 und einer segmentierten zweiten Außenelektrode 2, welche separate Elektrodensegmente 21, 22, 23, 24, 25 aufweist. Die separaten Elektrodensegmente 21, 22, 23, 24, 25 sind räumlich voneinander getrennt. Sie sind weder direkt elektrisch leitend miteinander verbunden noch berühren sie sich. Die erste Außenelektrode 4 ist mit einem Bezugspotenzial 7 verbunden. Die Elektrodensegmente 21, 22, 23, 24, 25 haben jeweils ein Terminal 210, 220, 230, 240, 250 über das sie mit einer Steueranordnung 6 verbunden sind. Über die Terminals 210, 220, 230, 240, 250 sind Ansteuersignale anlegbar.

Die segmentierte Außenelektrode 2 kann zum Beispiel durch Aufdrucken einer Metallpaste und einem darauf folgenden Metallisierungseinbrand erzeugt werden. Die Weiterkontaktierung kann beispielsweise durch Anlöten von metallischen Siebgewebestücken an die Metallisierungssegmente oder durch Anlöten von mehreren, einzelnen Drähten erfolgen.

Der Aktor 1 umfasst erste und zweite Innenelektroden 5, 3, welche mit der ersten Außenelektrode 4 beziehungsweise der zweiter Außenelektrode 2 elektrisch leitend verbunden sind. Der Aktor 1 umfasst eine Mehrzahl von Aktorabschnitten 81, 82, 83, 84, 85. Jeder sich axial erstreckte Aktorabschnitt 81, 82, 83, 84, 85 korrespondiert mit der axialen Ausdehnung der Elektrodensegmente 21, 22, 23, 24, 25. Das erste Elektrodensegment 21 ist elektrisch leitend mit den zweiten Innenelektroden 3 im ersten Aktorabschnitt 81 verbunden. Das zweite Elektrodensegment 22 ist elektrisch leitend mit den zweiten Innenelektroden 3 im zweiten Aktorabschnitt 82 verbunden. Das dritte Elektrodensegment 23 ist elektrisch leitend mit den zweiten Innenelektroden 3 im dritten Aktorabschnitt 83 verbunden. Das vierte Elektrodensegment 24 ist elektrisch leitend mit den zweiten Innenelektroden 3 im vierten Aktorabschnitt 84 verbunden. Das fünfte Elektrodensegment 25 ist elektrisch leitend mit den zweiten Innenelektroden 3 im fünften Aktorabschnitt 85 verbunden. Dagegen sind die ersten Innenelektroden 5 in den Aktorabschnitten 81, 82, 83, 84, 85 mit derselben ersten, durchgehenden Außenelektrode 4 elektrisch leitend verbunden. In einem anderem Ausführungsbeispiel ist auch die erste Außenelektrode 4 segmentiert.

Die elektrische Ansteuerung der Aktorabschnitte 81, 82, 83, 84, 85 mittels der Steueranordnung 6 kann durch mehrere unabhängige Stromquellen 61, 62, 63, 64, 65 durchgeführt werden. Alternativ kann ausgehend von einer Stromquelle ein zeitlicher Versatz zwischen den Ansteuerpulsen für die Aktorabschnitte 81, 82, 83, 84, 85 durch Vorschalten entsprechender Impedanzen realisiert werden.

Der Aktor 1 ist am Aktorfuß 91 beim fünften Abschnittssegment 85 fixiert, sodass sich beim axial dehnenden Aktor 1 der Aktorkopf 92 in eine Richtung 93 axial vom Aktorfuß 91 weg bewegt. Die Ansteuerung der Elektrodensegmente 21, 22, 23, 24, 25 erfolgt derart, dass zuerst der dem Aktorkopf 92 nächste Aktorabschnitt 81 angesteuert wird, dann zeitversetzt der dazu benachbarte Aktorabschnitt 82 und so weiter, bis als letztes der dem Aktorfuß 91 nächste Aktorabschnitt 85 angesteuert wird. Durch diese Ansteuerung werden die durch die Trägkeitskräfte auftretenden Belastungen reduziert, da zuerst der Abschnitt 81 des Aktors 1 in Bewegung versetzt wird oder Dehnung erfährt, welcher die größte Bewegungsänderung bei der Dehnung des Aktors 1 erfährt, was die Belastung mindert. Die oben beschriebene Zeitverzögerung kann sowohl bei den Signalen, mittels derer die Dehnung des Aktors 1 initiert wird, als auch bei den Signalen, mittels derer die Stauchung des Aktors 1 initiiert wird, oder nur bei einem von beiden aufgeprägt werden.

Figur 3 zeigt eine Anordnung zur Veranschaulichung der Funktionsweise der vorgeschlagenen sequentiellen elektrischen Ansteuerung von Aktoren 1, die eine Simulation der Aktordynamik ermöglicht. Das Simulationsmodell spiegelt Randbedingungen eines Aktorbetriebs in einem Injektionssystem vereinfacht wieder. Die mechanischen Randbedingungen sind einerseits die Auflage des Aktors 1 auf einer ideal steifen, festen Untergrundplatte, nämlich der festen Einspannung 12, und auf der gegenüberliegenden Seite die Kopplung an ein System aus Feder 10 und Schwungmasse 11, das bei einer Aktorauslenkung mitbewegt wird. Auf die Feder 10 wirkt eine Kraft 9. Die elektrische Ansteuerung des Aktors 1 erfolgt über die Vorgabe bestimmter Strompulse, das heißt Strombeziehungsweise Ladungssteuerung durch die Steueranordnung 6. In dem zugrundeliegenden eindimensionalen Simulationsmodell werden Aktorauslenkung und Kraft als Funktionen der Zeit und der Position entlang der Aktorachse berechnet, sowie die Aktorspannung.

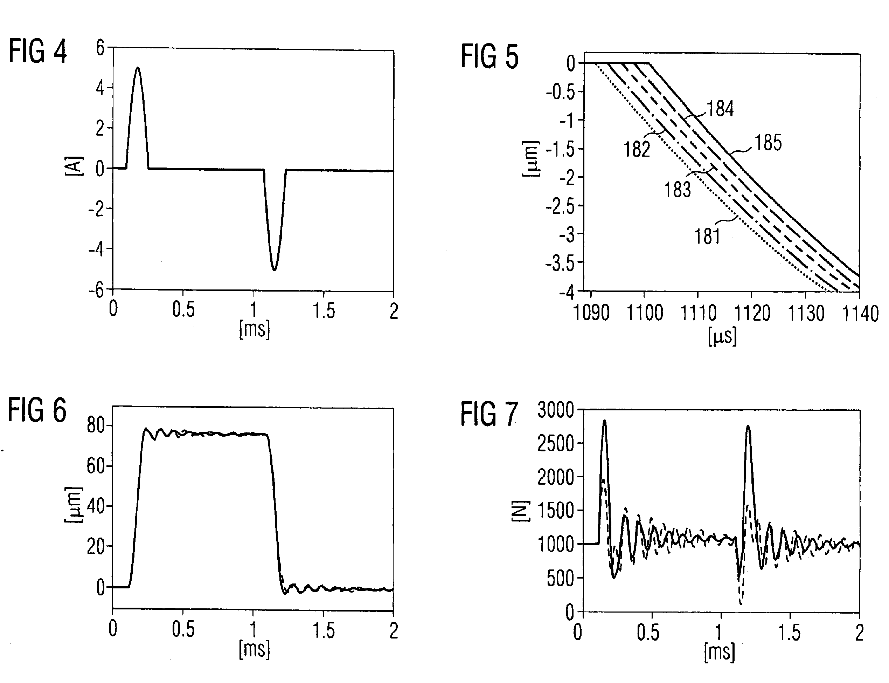

In den Figuren 4 bis 9 sind die Ergebnisse von zwei Simulationen von 40 mm langen Aktoren 1 dargestellt, die mit Strompulsen von 150 µs Schaltzeit angesteuert werden. Es wird ein Aktor 1 mit nicht segmentierten Außenelektroden 4, 2, wie in Figur 1 dargestellt, mit einem Aktor 1 mit einer zweiten Außenelektrode 2, welche fünf getrennt ansteuerbare Elektrodensegmente 21, 22, 23, 24, 25, wie in Figur 2 dargestellt, umfasst, verglichen. Der Zeitversatz zwischen Steuersignalen für benachbarte Elektrodensegmente beträgt 2,5 µs.

Figur 4 zeigt den zeitlichen Verlauf der Ansteuerung mit sinushalbwellenförmigen Strompulsen für den Aktor 1 mit segmentierter Außenelektrode 1. Es sind die Ströme über der Zeit dargestellt. Der zeitliche Verlauf des Signals zur Ansteuerung des Aktors 1 mit durchgehenden Außenelektroden entspricht dem Signal zur Ansteuerung eines der Segmente.

Figur 11 zeigt detailliert die Strompulse beim Ausschaltvorgang. Das Elektrodensegment 25, welches dem fest eingespannten Aktorfuß 91 am Nächsten ist, wird zuletzt angesteuert. Der entsprechende Signalverlauf ist mit einer durchgezogenen Linie veranschaulicht. Das Elektrodensegment 21, welches dem fest eingespannten Aktorfuß 91 am Fernsten beziehungsweise der Masse 11 am Nächsten ist, wird zuerst angesteuert. Der entsprechende Signalverlauf ist mit einer gepunkteten Linie veranschaulicht. Das Elektrodensegment 22, welches benachbart zum dem Aktorfuß 91 fernsten Elektrodensegment 21 ist, wird als nächstes angesteuert. Das dazu benachbarte Elektrodensegment 23 wird als nächstes angesteuert und das dazu benachbarte 24 danach. Das Elektrodensegment 25, welches dem fest eingespannten Aktorfuß 91 am Nächsten beziehungsweise der Masse 11 am Fernsten ist, wird zuletzt angesteuert. Der entsprechende Signalverlauf ist mit einer durchgezogenen Linie veranschaulicht.

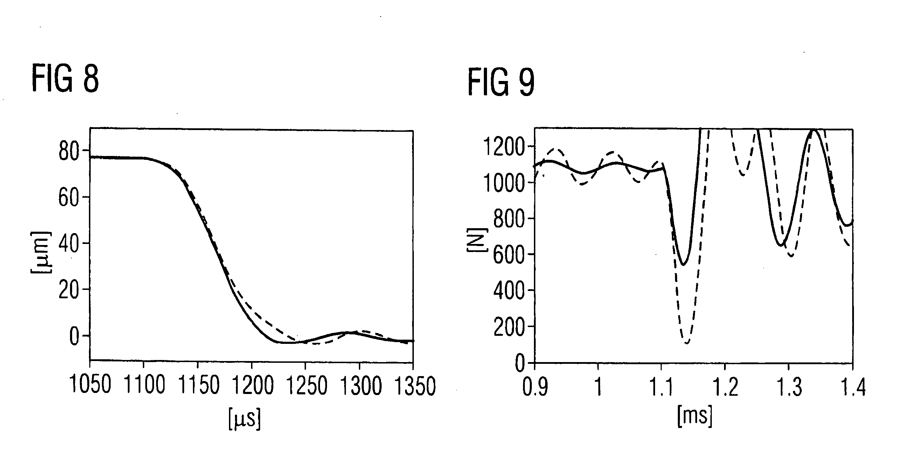

In der Figur 6 ist die Auslenkung oder der Hub über der Zeit am freien Aktorende 92. In Figur 7 ist die Kraft am fest eingespannten Aktorfuß 91 dargestellt. An dieser Stelle treten die größten Kraftamplituden auf. Die Ergebnisse für den Aktor 1 mit nicht segmentierten Außenelektroden ist in den Figuren 6 bis 9 als gestrichelte Linie dargestellt. Die Ergebnisse für den Aktor 1 mit einer segmentierten Außenelektrode 2 ist in den Figuren 6 bis 9 als durchgezogene Linie dargestellt. Figur 8 zeigt einen zeitlichen Ausschnitt aus Figur 6. Linie 181 zeigt die Ansteuerung des ersten Aktorabschnitts 81. Linie 182 zeigt die Ansteuerung des zweiten Aktorabschnitts 82. Linie 183 zeigt die Ansteuerung des dritten Aktorabschnitts 83. Linie 184 zeigt die Ansteuerung des vierten Aktorabschnitts 84. Linie 185 zeigt die Ansteuerung des fünften Aktorabschnitts 85. In dem angeführten Simulationsbeispiel ist die zeitliche Abfolge der Ansteuersignale für die Abschnitte bei Dehnung umgekehrt im Vergleich zur Abfolge bei Stauchung.

In Figur 7 sind die Kraftverläufe am fest eingespannten Aktorfuß 91 über der Zeit gezeigt. Ein Vergleich der Kraftverläufe zeigt, dass der Unterschwinger, der beim Ausschaltvorgang auftritt, im Fall des sequentiell angesteuerten Aktors 1 deutlich reduziert ist wie in Figur 9, die einen zeitlichen Ausschnitt aus Figur 7 im Detail zeigt, deutlich zu erkennen ist. Ausgeprägte Kraftunterschwinger mit beinahe vollständigem Verlust der Druckvorspannung, wie sie beim herkömmlichen Aktor auftreten, sind für einen Dauerbetrieb von Aktoren zu vermeiden. Die Simulation zeigt, dass auf Grund der sequentiellen Ansteuerung die minimale Vorspannkraft deutlich angehoben werden kann. Die Graphen in den Figuren 6 und 8 zeigen, dass durch die sequentielle Ansteuerung der verschiedenen Aktorabschnitte keine Schaltverzögerung im Aktorhub des Aktors auftritt, sondern der Schaltvorgang sogar beschleunigt wird.

Es sei bemerkt, dass die Merkmale der Ausführungsbeispiele kombinierbar sind.

### Bezugszeichen

- 1: Aktor
- 4, 2: Außenelektrode
- 5, 3: Innenelektrode
- 6: Steueranordnung
- 7: Bezugspotenzial
- 9: Kraft
- 10: Feder
- 11: Masse
- 12: Einspannung
- 16: Piezoelement
- 21, 21, 23, 24, 25: Elektrodensegment
- 61, 62, 63, 64, 65: Stromquellen
- 81, 82, 83, 84, 85: Aktorabschnitt
- 91: Aktorfuß
- 92: Aktorkopf
- 93: Richtung
- 210, 210, 230, 410, 420, 430: Terminal
- 181, 182, 183, 184, 185: Linie

## Patentansprüche

1. Aktorsystem mit einem Aktor (1) mit
- stapelförmig angeordneten Piezoelementen (16),
- ersten und zweiten Innenelektroden (5, 3), die zwischen den Piezoelementen (16) abwechselnd angeordnet sind,
- einer ersten Außenelektrode (4), die elektrisch leitend mit den ersten Innenelektroden (5) verbunden ist,
- einer zweiten Außenelektrode (2), die elektrisch leitend mit den zweiten Innenelektroden (3) verbunden ist,
wobei
der Aktor (1) eine Mehrzahl von Aktorabschnitten (81, 82, 83, 84, 85) umfasst und dass die zweite Außenelektrode (2) separate Elektrodensegmente (21, 22, 23, 24, 25) umfasst, die jeweils mit den zweiten Innenelektroden (3) in einem der Aktorabschnitte (81, 82, 83, 84, 85) elektrisch leitend verbunden sind, wobei ein erstes Ansteuersignal an einem der Aktorabschnitte (81, 82, 83, 84, 85) und ein zweites Ansteuersignal zeitversetzt an einem weiteren Aktorabschnitt (81, 82, 83, 84, 85) anlegbar ist
**dadurch gekennzeichnet, dass**
der Zeitversatz in Abhängigkeit der Trägheitskräfte im Aktor (1) gewählt wird.

2. Aktorsystem (1) nach Anspruch 1,
**dadurch gekennzeichnet, dass**
die erste Außenelektrode (4) separate Elektrodensegmente umfasst, die jeweils mit den ersten Innenelektroden (5) in einem der Aktorabschnitte (81, 82, 83, 84, 85) elektrisch leitend verbunden sind.

3. Aktorsystem (1) nach einem der vorhergehenden Ansprüche,
**dadurch gekennzeichnet, dass**
die Elektrodensegmente (21, 22, 23, 24, 25) der zweiten Außenelektrode (2) jeweils ein Terminal (210, 220, 230, 240, 250) umfassen, an denen ein Ansteuersignal (U1, U2, U3, U4, U5) anlegbar ist.

4. Aktorsystem nach einem der vorgehenden Ansprüche
**dadurch gekennzeichnet, dass**
der Aktor (1) in eine Richtung (93) ausdehnbar ist und dass ein erster Aktorabschnitt (81, 82, 83, 84, 85) in dieser Richtung (93) relativ zu einem zweiten Aktorabschnitt (81, 82, 83, 84, 85) angeordnet ist, wobei die Steueranordnung (6) geeignet ist, das zweite Ansteuersignal am zweiten Aktorabschnitt (81, 82, 83, 84, 85) zeitverzögert zum ersten Ansteuersignal am ersten Aktorabschnitt (81, 82, 83, 84, 85) anzulegen.

5. Ansteuerung eines Aktors (1) mit stapelförmig angeordneten Piezoelementen (16), ersten und zweiten Innenelektroden (5, 3), die zwischen den Piezoelementen (16) abwechselnd angeordnet sind, wobei der Aktor (1) eine Vielzahl von Aktorabschnitten (81, 82, 83, 84, 85) umfasst und zwischen den ersten und den zweiten Innenelektroden (5, 3) in einem ersten Aktorabschnitt (81, 82, 83, 84, 85) eine erste Ansteuerspannung zeitversetzt zu einer zweiten Ansteuerspannung zwischen den ersten und den zweiten Innenelektroden (5, 3) in einem zweiten Aktorabschnitt (81, 82, 83, 84 85) angelegt wird,
**dadurch gekennzeichnet, dass**
der Zeitversatz in Abhängigkeit der Trägheitskräfte im Aktor (1) gewählt wird.

6. Ansteuerung nach Anspruch 5,
**dadurch gekennzeichnet, dass**
der Aktor (1) in eine Richtung ausdehnbar ist, wobei der erste Aktorabschnitt (81, 82, 83, 84, 85) in der Richtung relativ zu dem zweiten Aktorabschnitt (81, 82, 83, 84, 85) angeordnet ist, und wobei die zweite Ansteuerspannung zur ersten Ansteuerspannung zeitverzögert ist.

## Claims

1. Actuator system comprising an actuator (1) comprising
- piezoelements (16) arranged in a stacked fashion,
- first and second internal electrodes (5, 3) arranged alternately between the piezoelements (16),
- a first external electrode (4), which is electrically conductively connected to the first internal electrodes (5),
- a second external electrode (2), which is electrically conductively connected to the second internal electrodes (3),
wherein
the actuator (1) comprises a plurality of actuator sections (81, 82, 83, 84, 85), and in that the second external electrode (2) comprises separate electrode segments (21, 22, 23, 24, 25), which are electrically conductively connected in each case to the second internal electrodes (3) in one of the actuator sections (81, 82, 83, 84, 85), wherein
a first actuation signal can be applied to one of the actuator sections (81, 82, 83, 84, 85) and a second actuation signal can be applied in a time-shifted manner to a further actuator section (81, 82, 83, 84, 85),
**characterized in that** the time shift is chosen in a manner dependent on the inertial forces in the actuator (1).

2. Actuator system (1) according to Claim 1,
**characterized in that**
the first external electrode (4) comprises separate electrode segments which are electrically conductively connected in each case to the first internal electrodes (5) in one of the actuator sections (81, 82, 83, 84, 85).

3. Actuator system (1) according to either of the preceding claims,
**characterized in that**
the electrode segments (21, 22, 23, 24, 25) of the second external electrode (2) in each case comprise a terminal (210, 220, 230, 240, 250), to which a control signal (U1, U2, U3, U4, U5) can be applied.

4. Actuator system according to any of the preceding claims,
**characterized in that**
the actuator (1) is expandable in one direction (93), and **in that** a first actuator section (81, 82, 83, 84, 85) is arranged in this direction (93) relative to a second actuator section (81, 82, 83, 84, 85), wherein the control arrangement (6) is suitable for applying the second control signal to the second actuator section (81, 82, 83, 84, 85) in a time-delayed manner with respect to the first actuation signal applied to the first actuator section (81, 82, 83, 84, 85).

5. Actuation of an actuator (1) comprising piezoelements (16) arranged in a stacked fashion, first and second internal electrodes (5, 3) arranged alternately between the piezoelements (16), wherein the actuator (1) comprises a multiplicity of actuator sections (81, 82, 83, 84, 85) and a first actuation voltage is applied between the first and second internal electrodes (5, 3) in a first actuator section (81, 82, 83, 84, 85) in a time-shifted manner with respect to a second actuation voltage applied between the first and second internal electrodes (5, 3) in a second actuator section (81, 82, 83, 84, 85),
**characterized in that**
the time shift is chosen in a manner dependent on the inertial forces in the actuator (1).

6. Actuation according to Claim 5,
**characterized in that**
the actuator (1) is expandable in one direction, wherein the first actuator section (81, 82, 83, 84, 85) is arranged in the direction relative to the second actuator section (81, 82, 83, 84, 85), and wherein the second actuation voltage is time-delayed with respect to the first actuation voltage.

## Revendications

1. Système d'actionneur comportant un actionneur (1) qui présente
des piézoéléments (16) disposés en pile,
des premières et des deuxièmes électrodes intérieures (5, 3) disposées en alternance entre les piézoéléments (16),
une première électrode extérieure (4) raccordée de manière électriquement conductrice aux premières électrodes intérieures (5),
une deuxième électrode extérieure (2) raccordée de manière électriquement conductrice aux deuxièmes électrodes intérieures (3),
l'actionneur (1) comportant plusieurs parties d'actionneur (81, 82, 83, 84, 85), la deuxième électrode extérieure (2) comportant des segments séparés d'électrode (21, 22, 23, 24, 25) qui sont tous raccordés de manière électriquement conductrice aux deuxièmes électrodes intérieures (3) d'une des parties d'actionneur (81, 82, 83, 84, 85),
un premier signal de commande pouvant être appliqué sur l'une des parties d'actionneur (81, 82, 83, 84, 85) et un deuxième signal de commande pouvant être appliqué avec un retard temporel sur une deuxième partie d'actionneur (81, 82, 83, 84, 85),
**caractérisé en ce que**
le retard temporel est sélectionné en fonction des forces d'inertie qui agissent dans l'actionneur (1).

2. Système d'actionneur (1) selon la revendication 1, **caractérisé en ce que** la première électrode extérieure (4) comporte des segments séparés d'électrode qui sont tous reliés de manière électriquement conductrice aux premières électrodes intérieures (5) de l'une des parties d'actionneur (81, 82, 83, 84, 85).

3. Système d'actionneur (1) selon l'une des revendications précédentes, **caractérisé en ce que** les segments d'électrodes (21, 22, 23, 24, 25) de la deuxième électrode extérieure (2) comportent tous une borne (210, 220, 230, 240, 250) sur laquelle un signal de commande (U1, U2, U3, U4, U5) peut être appliqué.

4. Système d'actionneur selon l'une des revendications précédentes, **caractérisé en ce que** l'actionneur (1) peut se dilater dans une direction (93) et **en ce qu'**une première partie d'actionneur (81, 82, 83, 84, 85) est disposée dans cette direction (93) par rapport à une deuxième partie d'actionneur (81, 82, 83, 84, 85), l'ensemble de commande (6) permettant d'appliquer le deuxième signal de commande sur la deuxième partie d'actionneur (81, 82, 83, 84, 85) avec un retard temporel par rapport au premier signal de commande appliqué sur la première partie d'actionneur (81, 82, 83, 84, 85).

5. Commande d'un actionneur (1) qui présente
des piézoéléments (16) disposés en pile,
des premières et des deuxièmes électrodes intérieures (5, 3) disposées en alternance entre les piézoéléments (16),
l'actionneur (1) comportant plusieurs parties d'actionneur (81, 82, 83, 84, 85) et une première tension de commande étant appliquée entre les premières et les deuxièmes électrodes intérieures (5, 3) d'une première partie d'actionneur (81, 82, 83, 84, 85) avec un retard temporel par rapport à une deuxième tension de commande appliquée entre les premières et les deuxièmes électrodes intérieures (5, 3) d'une deuxième partie d'actionneur (81, 82, 83, 84, 85), **caractérisée en ce que**
le retard temporel est sélectionné en fonction des forces d'inertie qui agissent dans l'actionneur (1).

6. Commande selon la revendication 5, **caractérisée en ce que** l'actionneur (1) peut se dilater dans une direction, **en ce que** la première partie d'actionneur (81, 82, 83, 84, 85) est disposée dans la direction par rapport à la deuxième partie d'actionneur (81, 82, 83, 84, 85) et **en ce que** la deuxième tension de commande présente un retard temporel par rapport à la première tension de commande.
